(19) Europäisches Patentamt
European Patent Office
Office européen des brevets

(11) Veröffentlichungsnummer: **0 026 299**
**B1**

(12) **EUROPÄISCHE PATENTSCHRIFT**

(45) Veröffentlichungstag der Patentschrift: **20.04.83**

(51) Int. Cl.³: **G 03 C 1/70**, G 03 F 7/10, C 08 L 79/04

(21) Anmeldenummer: **80104641.8**

(22) Anmeldetag: **06.08.80**

(54) **Verfahren zur Herstellung hochwärmebeständiger Reliefstrukturen, danach hergestellte Reliefstrukturen und deren Verwendung.**

(30) Priorität: **21.08.79 DE 2933871**

(43) Veröffentlichungstag der Anmeldung: **08.04.81 Patentblatt 81/14**

(45) Bekanntmachung des Hinweises auf die Patenterteilung: **20.04.83 Patentblatt 83/16**

(84) Benannte Vertragsstaaten: **AT BE CH DE FR GB IT LI NL SE**

(56) Entgegenhaltungen:
**DE A 2 211 242**
**FR A 2 129 360**
**FR A 2 425 094**
**US A 4 047 963**
**US A 4 144 073**

(73) Patentinhaber: **SIEMENS AKTIENGESELLSCHAFT**
**Berlin und München Wittelsbacherplatz 2**
**D-8000 München 2 (DE)**

(72) Erfinder: **Ahne, Hellmut, Dr.**
**Heidestrasse 6**
**D-8551 Röttenbach (DE)**
Erfinder: **Rubner, Roland, Dr.**
**Buchenring 15**
**D-8551 Röttenbach (DE)**
Erfinder: **Kühn, Eberhard**
**Bergstrasse 32**
**D-8551 Hemhofen (DE)**

**EP 0 026 299 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

# Verfahren zur Herstellung hochwärmebeständiger Reliefstrukturen, danach hergestellte Reliefstrukturen und deren Verwendung

Die Erfindung betrifft ein Verfahren zur Herstellung hochwärmebeständiger Reliefstrukturen durch Auftragen strahlungsempfindlicher löslicher Polymer-Vorstufen in Form einer Schicht oder Folie auf ein Substrat, Bestrahlen der Schicht bzw. Folie durch Negativvorlagen mit aktinischem Licht oder durch Führen eines Licht-, Elektronen- oder Ionenstrahls, Entfernen der nichtbestrahlten Schicht- bzw. Folienteile und gegebenenfalls durch nachfolgendes Tempern, sowie die Verwendung derart hergestellter Reliefstrukturen.

Ein Verfahren der genannten Art zur Herstellung von Reliefstrukturen auf der Basis von Polymeren ist aus der deutschen Patentschrift 2 308 830 bzw. der entsprechenden US-Patentschrift 3 957 512 bekannt. Bei diesem Verfahren werden als lösliche Polymer-Vorstufen Polyadditions- oder Polykondensationsprodukte polyfunktioneller carbocyclischer oder heterocyclischer, strahlungsempfindliche Reste tragender Verbindungen mit Diaminen, Diisocyanaten, Bis-säurechloriden oder Dicarbonsäuren verwendet. Die Verbindungen, die strahlungsempfindliche Reste tragen, enthalten dabei zwei für Additions- oder Kondensationsreaktionen geeignete Carboxyl-, Carbonsäurechlorid-, Amino-, Isocyanat- oder Hydroxylgruppen und teilweise in ortho- oder peri-Stellung dazu esterartig an Carboxylgruppen gebundene strahlungsreaktive Gruppen. Die mit diesen Verbindungen umzusetzenden Diamine, Diisocyanate, Bissäurechloride und Dicarbonsäuren weisen mindestens ein cyclisches Strukturelement auf.

Die löslichen Polymer-Vorstufen werden beim Bestrahlen vernetzt und gehen dabei in unlösliche Zwischenprodukte über. Diese Zwischenprodukte unterliegen bei der Temperung einer Cyclisierung, wobei hochwärmebeständige Polymere folgender Stoffklassen gebildet werden : Polyimide, Polyamidimide, Polyesterimide, Poly-1.3-chinazolin-2.6-dione, Polyisoindolochinazolindione, Poly-1.3-oxazin-6-one und Polybenz-1.3-oxazin-2.4-dione.

Aufgabe der Erfindung ist es, das Verfahren der eingangs genannten Art in der Weise weiter auszugestalten, daß das Angebot an hochwärmebeständigen Reliefstrukturen verbreitert wird.

Dies wird erfindungsgemäß dadurch erreicht, daß Vorstufen von Polyimidazolen und Polyimidazopyrrolonen in Form von Additionsprodukten olefinisch ungesättigter Monoepoxide an aminogruppenhaltige Polykondensationsprodukte von aromatischen und/oder heterocyclischen Tetraaminoverbindungen mit Dicarbonsäurechloriden oder -estern bzw. an aminogruppenhaltige Polyadditionsprodukte aus den Tetraaminoverbindungen und Tetracarbonsäuredianhydriden verwendet werden.

Reliefstrukturen auf der Basis von Polyimidazolen und Polyimidazopyrrolonen sind bislang noch nicht bekannt. Die nach dem erfindungsgemäßen Verfahren hergestellten Reliefstrukturen, die auf dieser Basis beruhen, weisen eine ausgezeichnete Temperaturbeständigkeit auf. Darüber hinaus sind diese Reliefstrukturen zum Teil in polaren organischen Lösungsmitteln, wie Dimethylsulfoxid, Dimethylacetamid, Dimethylformamid und N-Methylpyrrolidon, löslich und können deshalb — bei Bedarf — von Substraten auch wieder entfernt werden. Ferner zeichnet sich das erfindungsgemäße Verfahren dadurch aus, daß die verwendeten Polymer-Vorstufen zum Teil in wäßrig-alkalischen Medien löslich sind, d. h. daß die strahlungsreaktiven Vorstufen nach der Belichtung wäßrig-alkalisch entwickelt werden können. Dies ist insbesondere aus wirtschaftlichen und ökologischen Gründen von Interesse, da die Nachteile organischer Entwickler, wie Brennbarkeit und Toxizität, entfallen.

Beim erfindungsgemäßen Verfahren können die Polymer-Vorstufen vorteilhaft zusammen mit licht- oder strahlungsempfindlichen copolymerisationsfähigen Verbindungen eingesetzt werden. Dazu werden vorzugsweise N-substituierte Maleinimide verwendet. Es können aber auch acrylat- bzw. methacrylatgruppenhaltige Verbindungen eingesetzt werden. Weiter können auch übliche Photoinitiatoren und/oder -sensibilisatoren verwendet werden (vgl. ; « Industrie Chimique Belge », *24*, 1959, S. 739 bis 764, sowie J. Kosar, « Light-Sensitive Systems », John Wiley & Sons Inc., New York 1965, S. 143 bis 146 und S. 160 bis 188). Besonders geeignet sind Michlers Keton und/oder Benzoinäther, 2-tert. Butyl-9.10-anthrachinon, 1.2-Benz-9.10-anthrachinon und 4.4'-Bis(diäthylamino)-benzophenon. Ferner können beim erfindungsgemäßen Verfahren Haftvermittler verwendet werden. Dazu dienen insbesondere Silane, wie Vinyltriäthoxysilan, Vinyl-tris(β-methoxy-äthoxy)-silan, γ-Methacryloxypropyl-trimethoxysilan und γ-Glycidoxypropyl-trimethoxysilan.

Die beim erfindungsgemäßen Verfahren eingesetzten strahlungsreaktiven Vorstufen, die oligomerer und/oder polymerer Natur sind, sind in der gleichzeitig eingereichten europäischen Patentanmeldung « Polyimidazol- und Polyimidazopyrrolon-Vorstufen sowie deren Herstellung », Nr. 24 592, beschrieben. Diese Vorstufen weisen im allgemeinen folgende Struktur auf :

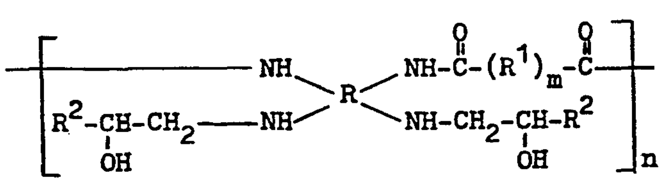

(1)

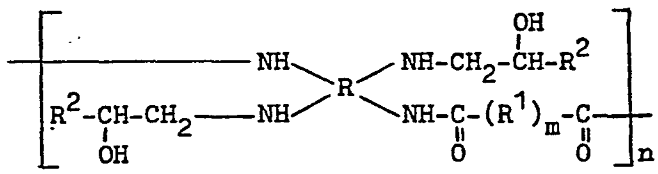

(2)

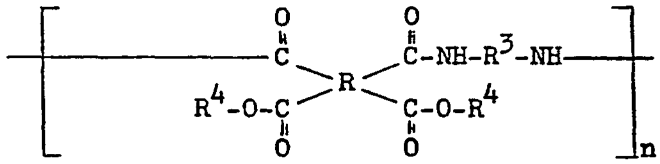

(3)

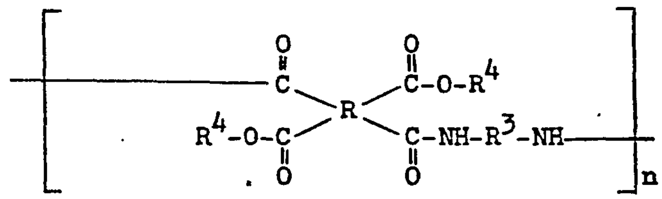

(4)

In den Formeln (1) bis (4) bedeutet n eine ganze Zahl von 2 bis etwa 100 und m ist 0 oder 1. Die Formeln (1) und (2) zeigen dabei Polyimidazol-Vorstufen, die Formeln (3) und (4) Polyimidazopyrrolon-Vorstufen.

Für R, $R^1$, $R^2$, $R^3$ und $R^4$ gilt folgendes :

R ist ein — gegebenenfalls halogenierter — zumindest partiell aromatischer und/oder heterocyclischer tetravalenter, d. h. tetrafunktioneller Rest, bei dem jeweils zwei Valenzen in Nachbarstellung zueinander angeordnet sind ; weist der Rest R mehrere aromatische und/oder heterocyclische Strukturelemente auf, so befinden sich die Valenzpaare jeweils an endständigen derartigen Strukturelementen ;

$R^1$ ist ein — gegebenenfalls halogenierter — divalenter, d. h. difunktioneller Rest aliphatischer und/oder cycloaliphatischer, gegebenenfalls Heteroatome aufweisender, und/oder aromatischer und/oder heterocyclischer Struktur ;

$R^2$ ist ein olefinisch ungesättigter Rest, beispielsweise eine allylätherhaltige Gruppe, insbesondere eine — gegebenenfalls substituierte — (meth)acrylester-haltige Gruppe ;

$R^3$ ist ein zumindest partiell aromatischer und/oder heterocyclischer divalenter, d. h. difunktioneller Rest, bei dem wenigstens zu einer der beiden Valenzen in Nachbarstellung eine Aminogruppe angeordnet ist ; weist $R^3$ mehrere aromatische und/oder heterocyclische Strukturelemente auf, so befinden sich die freien Valenzen jeweils an endständigen derartigen Strukturelementen ;

$R^4$ ist Wasserstoff oder ein mit $R^2$ substituierter Hydroxyalkylrest.

Bevorzugt sind dabei Additionsprodukte von Glycidylacrylat oder -methacrylat an das Polykondensationsprodukt aus Diaminobenzidin und Isophthalsäuredimethylester und Additionsprodukte von Glycidylacrylat oder -methacrylat an das Polyadditionsprodukt aus Diaminobenzidin und Pyromellithsäuredianhydrid. Beispiele für derartige Polymer-Vorstufen sind in den nachfolgenden Formeln (5) und (6) dargestellt :

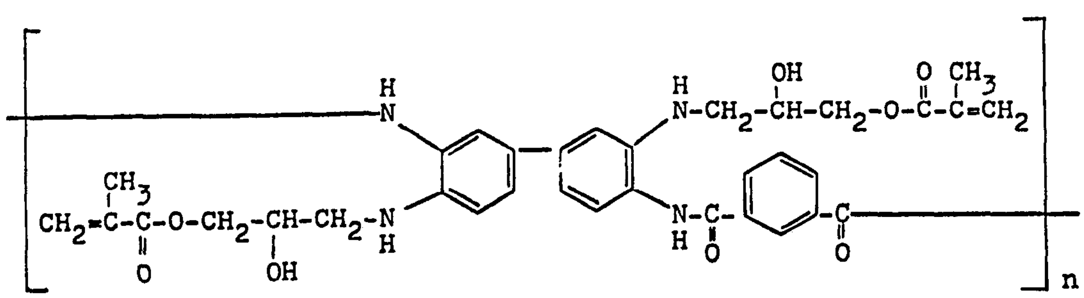

(5)

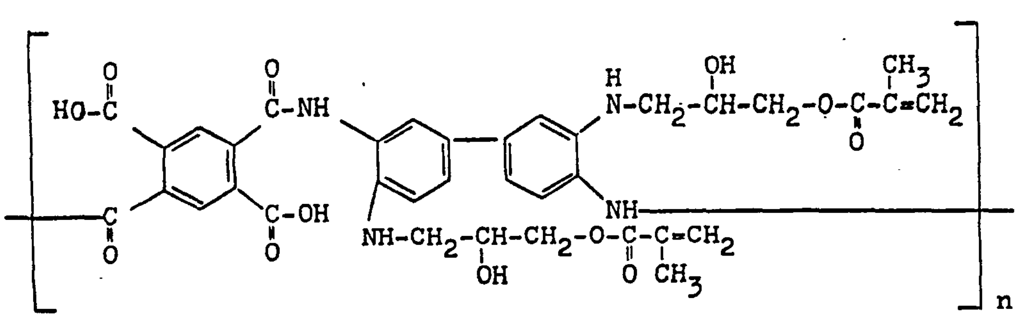

(6)

Formel (5) zeigt dabei eine Polyimidazol-Vorstufe,
Formel (6) eine Polyimidazopyrrolon-Vorstufe.

Die Herstellung der erfindungsgemäßen Reliefstrukturen erfolgt, wie bereits ausgeführt, in der Weise, daß die Polymer-Vorstufe in Form einer Schicht oder Folie auf ein Substrat aufgebracht und mit aktinischem Licht durch eine Maske belichtet oder durch Führen eines Licht-, Elektronen- oder Ionenstrahls bestrahlt wird; anschließend werden die nichtbelichteten bzw. nichtbestrahlten Schicht- oder Folienteile herausgelöst oder abgezogen und die dabei erhaltenen Reliefstrukturen werden gegebenenfalls getempert. Die Vorstufe kann vorteilhaft in einem organischen Lösungsmittel gelöst auf das Substrat aufgebracht werden; vorzugsweise wird als Lösungsmittel N-Methylpyrrolidon verwendet. Die Konzentration der Lösung kann so eingestellt werden, daß mit bekannten Beschichtungsverfahren, wie Schleudern, Tauchen, Sprühen, Bürsten oder Rollen, Schichtstärken von 0,01 µm bis einige 100 µm erzeugt werden können. Es hat sich gezeigt, daß beispielsweise beim Schleuderbeschichten 300 bis 10 000 Umdrehungen pro Minute für die Dauer von 1 bis 100 Sekunden geeignet sind, um eine gleichmäßige und gute Oberflächenqualität zu erzielen. Die auf das Substrat, das vorzugsweise aus Glas, Metall, Kunststoff oder halbleitendem Material besteht, aufgebrachte Photoresistschicht kann bei Raumtemperatur oder bei erhöhter Temperatur, vorzugsweise bei einer Temperatur von 50 bis 80 °C, in einem Stickstoff- oder Luftstrom vom Lösungsmittel befreit werden; dabei kann auch im Vakuum gearbeitet werden.

Zur Erzielung eines ausreichenden Löslichkeitsunterschiedes zwischen den bestrahlten und den nichtbestrahlten Schicht- bzw. Folienteilen genügen beim erfindungsgemäßen Verfahren — bei der Verwendung einer 500 W-Quecksilberhöchstdrucklampe — in Abhängigkeit von der Zusammensetzung und der Schichtstärke Belichtungszeiten zwischen 20 und 800 Sekunden. Nach dem Belichten werden die nichtbelichteten Teile der Schicht bzw. Folie herausgelöst, vorzugsweise wäßrig-alkalisch oder auch mit einem organischen Entwickler.

Mittels des erfindungsgemäßen Verfahrens werden konturenscharfe Bilder, d. h. Reliefstrukturen, erhalten, die durch Temperung in hochwärmebeständige, gegenüber Säuren und Laugen resistente Polymere umgewandelt werden. Im allgemeinen können Temperaturen von 220 bis 500 °C gewählt werden, vorzugsweise wird bei Temperaturen von 300 bis 400 °C getempert. Die Temperzeit beträgt im allgemeinen eine halbe Stunde, wobei unter Stickstoff keine Verfärbung zu beobachten ist. Die Kantenschärfe und die Maßgenauigkeit der Reliefstrukturen werden durch die Temperung praktisch nicht beeinträchtigt. Darüber hinaus bleibt die gute Oberflächenqualität der Reliefstrukturen trotz eines beim Tempern eintretenden Schichtstärkenverlustes erhalten.

Beim erfindungsgemäßen Verfahren werden vorzugsweise Polymer-Vorstufen aus aromatischen Komponenten eingesetzt, so daß bei der thermischen Behandlung, d. h. bei der Temperung, Polymere mit folgenden Struktureinheiten gebildet werden:

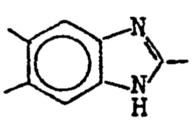
(7)

Polyimidazol

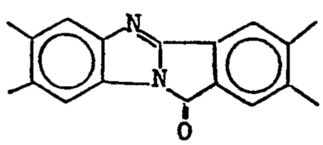
(8)

Polyimidazopyrrolon

Die genannten Verbindungsklassen zählen zu den Halb-Leiterpolymeren bzw. Leiterpolymeren und zeichnen sich durch eine hohe Temperaturbeständigkeit aus (bis zu ca. 500 °C).

Die erfindungsgemäßen Reliefstrukturen können zur Herstellung von Passivierungsschichten auf Halbleiterbauelementen, von Dünn- und Dickfilmschaltungen, von Lötschutzschichten auf Mehrlagenschaltungen, von Isolierschichten als Bestandteil von Schichtschaltungen und von miniaturisierten Isolierschichten auf elektrisch leitenden und/oder halbleitenden und/oder isolierenden Basismaterialien, insbesondere im Bereich der Mikroelektronik oder allgemein für die Feinstrukturierung von Substraten, Anwendung finden. Vorzugsweise dienen die hochwärmebeständigen Reliefstrukturen als Masken für Naß- und Trockenätzprozesse, stromlose oder galvanische Metallabscheidung und Aufdampfverfahren sowie als Masken für die Ionenimplantation, darüber hinaus als Isolier- und Schutzschichten in der Elektrotechnik. Reliefstrukturen auf der Basis von Polyimidazolen können dabei vorteilhaft dann eingesetzt werden, wenn die Reliefstruktur eine intermediäre Schutzfunktion ausüben soll; diese Reliefstrukturen sind nämlich in polaren Lösungsmitteln löslich und können deshalb leicht wieder entfernt werden. Ferner können die erfindungsgemäß hergestellten Reliefstrukturen vorteilhaft als Orientierungsschichten, beispielsweise in Flüssigkristalldisplays, sowie zur Rasterung von Oberflächen, beispielsweise bei Röntgenschirmen, insbesondere Röntgenbildverstärkern, verwendet werden.

Anhand von Ausführungsbeispielen soll die Erfindung noch näher erläutert werden.

## Beispiel 1

Herstellung einer strahlungsreaktiven Polybenzimidazol-Vorstufe

10,4 Gewichtsteile 3.3'-Diaminobenzidin werden in 25 Volumenteilen N-Methylpyrrolidon gelöst und zusammen mit 9,7 Gewichtsteilen Isophthalsäuredimethylester 8 Stunden lang auf eine Temperatur von 150 bis 175 °C und anschließend 2 Tage auf ca. 185 °C erhitzt. Zu dieser Lösung werden 20 Volumenteile Glycidylmethacrylat gegeben. Dieses Gemisch wird 48 Stunden bei Raumtemperatur und anschließend 4 Stunden auf einer Temperatur von etwa 50 bis 60 °C gehalten.

Herstellung der Reliefstruktur

Zu 14 Volumenteilen der auf die vorstehend beschriebene Weise hergestellten Lösung der Polybenzimidazol-Vorstufe werden 0,2 Gewichtsteile N-Phenylmaleinimid und 0,04 Gewichtsteile Michlers Keton gegeben. Die dabei erhaltene Lösung wird bei 1 000 Umdrehungen pro Minute auf eine Aluminiumfolie zu einem 10 µm starken Film geschleudert. Nach 2 stündiger Trocknung bei ca. 60 °C im Vakuum wird 3 Minuten lang mit einer 500 W-Quecksilberhöchstdrucklampe durch eine Maske kontaktbelichtet. Danach wird für 10 bis 15 Sekunden mit einer Mischung von Äthanol und N-Methylpyrrolidon im Volumenverhältnis 9 : 1 entwickelt, wobei Strukturen von 80 bis 100 µm erhalten werden. Nach einer 1 stündigen Temperung bei ca. 370 °C wird eine Schichtstärke von 4 bis 5 µm erhalten. Durch die Temperung erfolgt dabei keine Beeinträchtigung der Qualität der Reliefstruktur.

Beispiel 2

Herstellung einer strahlungsreaktiven Polyimidazopyrrolon-Vorstufe

In einem mit Stickstoff bespülten Reaktionskolben wird eine Lösung von 21,4 Gewichtsteilen (0,1 Mol) Diaminobenzidin in 190 Volumenteilen Dimethylacetamid vorgelegt. Zu dieser Lösung werden zunächst unter kräftigem Rühren rasch 190 Volumenteile einer Lösung von 21,8 Gewichtsteilen Pyromellithsäuredianhydrid (0,1 Mol) in 195 Volumenteilen Dimethylacetamid gegeben. Die erhaltene Prepolymer-Lösung wird ca. 30 Minuten langsam gerührt, wobei sie sich auf Raumtemperatur abkühlt. Danach wird die restliche Pyromellithsäuredianhydridlösung zugetropft. Nach beendeter Zugabe dieser Lösung wird die strohgelbe Prepolymer-Lösung leicht viskos. Wichtig ist dabei, daß reine Ausgangsmaterialien und Lösungsmittel verwendet werden.

Zu 44 Volumenteilen der in der vorstehend beschriebenen Weise erhaltenen Prepolymer-Lösung werden bei Raumtemperatur unter Rühren 15 Gewichtsteile Glycidylmethacrylat (0,1 Mol) getropft. Nach etwa 30 Minuten wird die Reaktionslösung für 12 Stunden auf etwa 50 bis 60 °C erwärmt, danach auf Raumtemperatur abgekühlt und für 48 Stunden stehengelassen. Anschließend wird die Lösung unter kräftigem Rühren zu 1 000 Volumenteilen Isopropanol getropft. Hierbei scheidet sich eine gelbbraune Substanz ab, die im Vakuum getrocknet wird.

Herstellung der Reliefstruktur

10 Gewichtsteile der auf die vorstehend beschriebene Weise hergestellten Polyimidazopyrrolon-Vorstufe, 0,5 Gewichtsteile N-Phenylmaleinimid und 0,3 Gewichtsteile Michlers Keton werden in 50 Volumenteilen einer Mischung von Dimethylacetamid und Dioxan (Volumenverhältnis 1 : 1) gelöst. Die Lösung wird bei 1 000 Umdrehungen pro Minute auf eine Aluminiumfolie zu einem Film geschleudert. Nach 1 stündigem Trocknen bei ca. 60 °C im Vakuum (Filmstärke : 3,3 µm) wird mit einer 500 W-Quecksilberhöchstdrucklampe durch eine Negativmaske 4 Minuten lang kontaktbelichtet, anschließend wird 45 Sekunden lang mit einer 1 %igen Natriumphosphatlösung entwickelt. Dabei werden konturenscharfe Reliefstrukturen mit einem Auflösungsvermögen $\leq$ 10 µm erhalten, die auch durch 45 minütiges Tempern bei ca. 400 °C keine Beeinträchtigung erfahren. Die Endschichtstärke beträgt 1,6 µm.

**Ansprüche**

1. Verfahren zur Herstellung hochwärmebeständiger Reliefstrukturen durch Auftragen strahlungsempfindlicher löslicher Polymer-Vorstufen in Form einer Schicht oder Folie auf ein Substrat, Bestrahlen der Schicht bzw. Folie durch Negativvorlagen mit aktinischem Licht oder durch Führen eines Licht-, Elektronen- oder Ionenstrahls, Entfernen der nichtbestrahlten Schicht- bzw. Folienteile und gegebenenfalls durch nachfolgendes Tempern, dadurch gekennzeichnet, daß Vorstufen von Polyimidazolen und Polyimidazopyrrolonen in Form von Additionsprodukten olefinisch ungesättigter Monoepoxide an aminogruppenhaltige Polykondensationsprodukte von aromatischen und/oder heterocyclischen Tetraaminoverbindungen mit Dicarbonsäurechloriden oder -estern bzw. an aminogruppenhaltige Polyadditionsprodukte aus den Tetraaminoverbindungen und Tetracarbonsäuredianhydriden verwendet werden.

2. Verfahren nach Anspruch 1, dadurch gekennzeichnet, daß die Polymer-Vorstufen zusammen mit licht- oder strahlungsempfindlichen copolymerisationsfähigen Verbindungen eingesetzt werden.

3. Verfahren nach Anspruch 2, dadurch gekennzeichnet, daß N-substituierte Maleinimide verwendet werden.

4. Verfahren nach einem der Ansprüche 1 bis 3, dadurch gekennzeichnet, daß ein Additionsprodukt von Glycidylacrylat oder -methacrylat an das Polykondensationsprodukt aus Diaminobenzidin und Isophthalsäuredimethylester verwendet wird.

5. Verfahren nach einem der Ansprüche 1 bis 3, dadurch gekennzeichnet, daß ein Additionsprodukt von Glycidylacrylat oder -methacrylat an das Polyadditionsprodukt aus Diaminobenzidin und Pyromellithsäuredianhydrid verwendet wird.

6. Hochwärmebeständige Reliefstruktur, hergestellt nach einem der Ansprüche 1 bis 5.

7. Verwendung der Reliefstruktur nach Anspruch 6 als Resist mit intermediärer Schutzfunktion zur lithographischen Strukturierung von Oberflächen, insbesondere bei Trockenätzverfahren.

8. Verwendung der Reliefstruktur nach Anspruch 6 zur dauerhaften Beschichtung oder Rasterung von Oberflächen.

9. Verwendung der Reliefstruktur nach Anspruch 6 als Schutz- und Isolierstoff in der Elektrotechnik.

**Claims**

1. A process for the production of high-temperature resistant relief structures by application of radiation-sensitive, soluble preliminary-stage polymers in the form of a layer or film, to a substrate, irradiation of the layer or film through negatives with actinic light or by the application of a beam of light, electrons, or ions, removal of the non-irradiated parts of the layer or film, and possibly-subsequent annealing, characterised in that preliminary stages of polyimidazoles and polyimidazopyrrolones are used, in the form of addition products of olefinically unsaturated mono-epoxides to amino group-containing polycondensation products of aromatic and/or heterocyclic tetra-amino compounds with dicarboxylic acid chlorides or esters, or to amino group-containing polyaddition products of the tetra-amino compounds and tetra-carboxylic acid dianhydrides.

2. A process according to Claim 1, characterised in that the preliminary-stage polymers are used together with copolymerisable compounds which are sensitive to light or radiation.

3. A process according to Claim 2, characterised in that N-substituted maleic imides are used.

4. A process according to one of Claims 1 to 3, characterised in that an addition product of glycidyl acrylate or methacrylate with the polycondensation product of diaminobenzidine and isophthalic acid dimethylester is used.

5. A process according to one of Claims 1 to 3, characterised in that an addition product of glycidyl acrylate or methacrylate with the polyaddition product of diaminobenzidine and pyromellitic acid dianhydride is used.

6. A high-temperature resistant relief structure produced in accordance with one of Claims 1 to 5.

7. The use of the relief structure according to Claim 6 as a resist having an intermediate protective function in the lithographic structuring of surfaces, in particular, in dry-etching processes.

8. The use of the relief structure according to Claim 6 for the permanent coating or gridding of surfaces.

9. The use of the relief structure according to Claim 6 as a protective and insulating material in electrical technology.

**Revendications**

1. Procédé de fabrication de structures en relief stables à haute température en appliquant sur un substrat des précurseurs de polymères solubles sensibles à un rayonnement sous la forme d'une couche ou d'une feuille, en exposant la couche ou feuille à de la lumière actinique à travers des modèles négatifs, ou en envoyant un faisceau lumineux, d'électrons ou d'ions, en éliminant les parties de couche ou feuille non exposées et éventuellement en soumettant à un recuit ultérieur, caractérisé en ce qu'il consiste à utiliser des précurseurs de polyimidazoles et de polyimidazopyrrolones sous forme de produits d'addition de monoépoxydes insaturés oléfiniquement sur des produits de polycondensation, contenant des groupes amino, de composés tétraamino aromatiques et/ou hétérocycliques et de chlorures ou d'esters d'acides dicarboxyliques ou sur des produits de polyaddition, contenant des groupes amino, constitués de composés tétraamino et de dianhydrides d'acides tétracarboxyliques.

2. Procédé suivant la revendication 1, caractérisé en ce qu'il consiste à utiliser les précurseurs de polymère en même temps que des composés aptes à copolymériser, sensibles à la lumière ou à un rayonnement.

3. Procédé suivant la revendication 2, caractérisé en ce qu'il consiste à utiliser des maléinimides substitués sur l'azote.

4. Procédé suivant l'une des revendications 1 à 3, caractérisé en ce qu'il consiste à utiliser un produit d'addition d'acrylate de glycidyle ou de méthacrylate de glycidyle sur le produit de polycondensation constitué de diaminobenzidine et d'ester diméthylique de l'acide isophtalique.

5. Procédé suivant l'une des revendications 1 à 3, caractérisé en ce qu'il consiste à utiliser un produit d'addition d'acrylate de glycidyle ou de méthacrylate de glycidyle sur le produit de polyaddition constitué

de diaminobenzidine et du dianhydride d'acide pyromellitique.

6. Structures en relief stables à haute température fabriquées par le procédé suivant l'une des revendications 1 à 5.

7. Utilisation de la structure en relief suivant la revendication 6 comme agent photorésistant ayant une fonction intermédiaire de protection pour la structuration par voie lithographique de surfaces, notamment dans un procédé d'attaque à sec.

8. Utilisation de la structure en relief suivant la revendication 6 pour le revêtement ou le quadrillage permanent de surfaces.

9. Utilisation de la structure en relief suivant la revendication 6 comme couche de protection et isolante dans la technique électronique.